# EUROPÄISCHE PATENTANMELDUNG

(11) **EP 4 733 082 A1**
(43) Veröffentlichungstag der Anmeldung: **29.04.2026**
(21) Anmeldenummer: 25197082.8
(22) Anmeldetag: 20.08.2025
(51) Int. Cl.: B42D 25/324, B42D 25/328, B42D 25/364, B42D 25/391, B42D 25/425

(54) **SICHERHEITSELEMENT MIT MOTIVBILDENDER FLÜSSIGKRISTALLSCHICHT UND ENTSPRECHENDES HERSTELLUNGSVERFAHREN**

(30) Priorität: 25.10.2024 DE 102024131191
(71) Anmelder: Giesecke+Devrient Currency Technology GmbH, 81677 München (DE)
(72) Erfinder: Teufel, Björn, 81677 München (DE); Schinabeck, Josef, 81677 München (DE); Hoffmüller, Winfried, 81677 München (DE); Rauch, Andreas, 81677 München (DE)
(74) Vertreter: Giesecke+Devrient IP

(57) **Zusammenfassung**

Die Erfindung betrifft ein Sicherheitselement (20) zur Absicherung von Wertgegenständen (10), mit einer Motivschicht auf Basis eines flüssigkristallinen Materials, das zu Ausbildung eines latenten Motivs ausgelegt und bestimmt ist. Erfindungsgemäß ist dabei vorgesehen, dass das Sicherheitselement (20) eine auf einer Trägerfolie (22) angeordnete erste Prägelackschicht (26), eine auf der ersten Prägelackschicht (26) partiell vorliegende Motivschicht (30) auf Basis eines nematischen flüssigkristallinen Materials und eine ein- oder mehrschichtige vollflächig vorliegende zweite Prägelackschicht (34) umfasst. Die dem nematischen flüssigkristallinen Material zugewandte Oberfläche der ersten Prägelackschicht (26) ist mit einer Prägung versehen, die zur Ausbildung eines zweiten latenten Motivs zumindest zwei Bereiche (28A, 28B) mit Ausrichtungsstrukturen unterschiedlicher Orientierung aufweist. Zumindest eine der Ausrichtungsstrukturen der motivbildenden Bereiche (28A, 28B) bildet ein Gittermuster mit Strichgitterlinien, deren Beabstandung über die Fläche des motivbildenden Bereichs variiert, so dass die Ausrichtungsstruktur ein aperiodisches Gitter bildet. Die Motivschicht (30) ist in Form eines ersten latenten Motivs bereichsweise direkt auf der ersten Prägelackschicht (26) und überlappend mit den das zweite latente Motiv bildenden Bereichen (28A, 28B) angeordnet. Dabei ist das nematische flüssigkristalline Material durch die motivbildenden Bereiche in Form des zweiten latenten Motivs mit jeweils unterschiedlicher Orientierung homogen ausgerichtet, so dass das von den unterschiedlichen Ausrichtungsstrukturen gebildete Motiv bei Betrachtung durch einen Polarisator erkennbar ist. Die zweite Prägelackschicht (24) ist mit einer Prägung zur Erzeugung einer mikrooptischen Reliefstruktur (38) und einer reflexionserhöhenden Beschichtung (36) versehen.

## Beschreibung

Die Erfindung betrifft ein Sicherheitselement zur Absicherung von Wertgegenständen, mit einer Motivschicht auf Basis eines flüssigkristallinen Materials, das zu Ausbildung eines latenten Motivs ausgelegt und bestimmt ist. Die Erfindung betrifft ferner ein zugehöriges Herstellungsverfahren sowie einen Datenträger mit einem derartigen Sicherheitselement.

Datenträger, wie Wert- oder Ausweisdokumente, aber auch andere Wertgegenstände, wie etwa Markenartikel, werden zur Absicherung oft mit Sicherheitselementen versehen, die eine Überprüfung der Echtheit der Datenträger gestatten und die zugleich als Schutz vor unerlaubter Reproduktion dienen. Eine besondere Rolle bei der Echtheitsabsicherung spielen Sicherheitselemente mit betrachtungswinkelabhängigem oder dreidimensionalem Erscheinungsbild, da diese selbst mit modernsten Kopiergeräten nicht reproduziert werden können.

Vielfach werden auch die besonderen Eigenschaften von flüssigkristallinen Materialien ausgenutzt, und dabei vor allem der betrachtungswinkelabhängige Farbeindruck und/oder die lichtpolarisierende Wirkung der Flüssigkristalle.

Solche Materialien sind nach dem Auftragen auf einen Träger praktisch unsichtbar, zeigen jedoch bei entsprechendem Untergrund, z.B. einem reflektierenden Druckträger, und unter Zuhilfenahme von linearen oder zirkularen Polarisatoren ausgeprägte visuelle optische Effekte. Erst bei Betrachtung durch einen linearen oder zirkularen Polarisator treten die beschichteten Bereiche mehr oder minder optisch hervor. Dabei können die Eindrücke zusätzlich in hohem Maße von der (Winkel-)Stellung des Polarisators abhängig sein.

Die hierbei eingesetzten Verfahren basieren beispielsweise darauf, dass die nematische Flüssigkristallschicht über einer spiegelnden Metallschicht bereitgestellt ist, um eine gute Erkennbarkeit der Polarisationseffekte zu ermöglichen. In der Druckschrift WO 2005/105475 A1 ist ein Verfahren beschrieben, bei dem das nematische flüssigkristalline Material, beispielsweise ein lösungsmittelbasierter UV-vernetzbarer Flüssigkristalllack, auf eine Trägerfolie musterförmig aufgedruckt wird.

Die bei diesen Verfahren eingesetzten Kunststoff-Trägerfolien haben aufgrund ihrer inneren Struktur eine Vorzugsrichtung (in Laufrichtung), die ausreicht, um das flüssigkristalline Material in der gewünschten Form auszurichten. Insbesondere eignen sich Kunststofffolien, die eine bei der Herstellung entstandene Oberflächenstruktur aufweisen, wie beispielsweise PET-Folien.

Über die Trägerfolie und die Nematenschicht wird dann in einem weiteren Arbeitsschritt vollflächig eine UV-härtbare Prägelackschicht aufgedruckt. In die Prägelackschicht wird eine gewünschte Prägestruktur, z.B. eine Beugungsstruktur, eingeprägt und eine reflektierende Schicht, z.B. in Form einer Metallschicht, aufgebracht, insbesondere aufgedampft, in die durch partielle Demetallisierung Aussparungen eingebracht werden können. Zuletzt wird für den Transfer auf ein Zielsubstrat (z. B. Papier) eine haftvermittelnde bzw. Primer-Schicht und auf diese eine Klebeschicht auf den Schichtverbund aufgebracht.

Von oben betrachtet ergibt sich daraus die folgende Schichtenfolge: nematische Flüssigkristalle, UV-Lack (mit Prägestruktur), Metallisierung. Der im Zusammenhang mit nematischen Flüssigkristallen zu beobachtende optische Effekt basiert auf der Bildung einer optisch anisotropen bzw. die Polarisation von Licht beeinflussenden Schicht. Ohne Hilfsmittel betrachtet zeigt der Schichtverbund daher lediglich die durch die Prägestruktur bereitgestellten optisch variablen Beugungsstrukturen, wie etwa Hologramme. Wird dieser hingegen durch einen zirkularen Polarisationsfilter betrachtet, so treten zusätzliche Strukturen in Erscheinung. Bereiche mit Metallisierung und ohne nematische Flüssigkristallschicht erscheinen schwarz oder zumindest dunkel, während Bereiche mit nematischen Flüssigkristallen ein helles Erscheinungsbild zeigen. Eine horizontale Drehung des zirkularen Polarisationsfilters führt dabei zu keiner Kontraständerung.

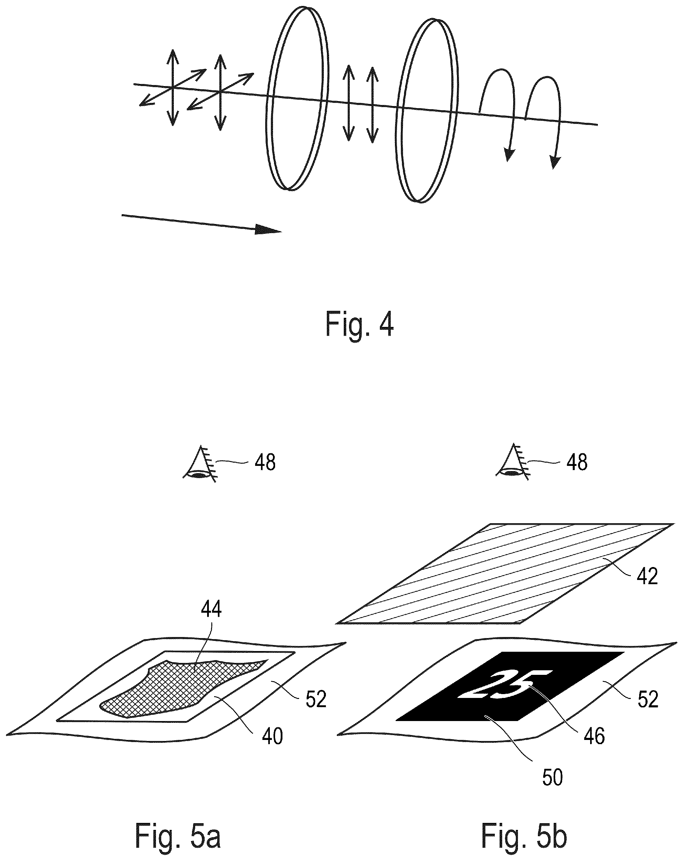

Die Funktionsweise eines Zirkularpolarisators wird nachfolgend am Beispiel von Metallschichten erläutert. Fig. 4 zeigt dazu eine schematische Darstellung eines Zirkularpolarisators. Dieser setzt sich aus einer ersten Schicht in Form eines linearen Polarisationsfilters und einer zweiten Schicht in Form einer um 45° gegenüber dem Polarisationsfilter gedrehten λ/4-Schicht bzw. einem "λ/4-Plättchen" zusammen. Trifft nun isotropes Licht auf den Zirkularpolarisator, lässt die erste, als linearer Polarisationsfilter wirkende Schicht nur linear polarisiertes Licht durch. Das durchgelassene linear polarisierte Licht trifft auf die um 45° gegenüber dem linearen Polarisationsfilter gedrehte λ/4-Schicht, die das linear polarisierte Licht in zirkular polarisiertes Licht umwandelt. Das zirkular polarisierte Licht wiederum wird an der metallischen Oberfläche reflektiert und von der zweiten Schicht in linear polarisiertes Licht mit um 90°gedrehter Polarisationsebene umgewandelt. Da die erste Schicht das Licht mit nunmehr gedrehter Polarisationsebene nicht durchlässt, erscheinen metallische Schichten bei Betrachtung mit einem Zirkularpolarisator dunkel.

Alternativ zur Betrachtung mit einem zirkularen Polarisationsfilter können die Strukturen auch mit einem linearen Polarisationsfilter (oder einem durch die Rückseite betrachteten, also "umgedrehten" zirkularen Polarisationsfilter) sichtbar gemacht werden. In diesem Fall erscheinen die metallisch beschichteten Bereiche ohne Flüssigkristallbeschichtung immer hell. In den zusätzlich mit dem nematischen flüssigkristallinen Material versehenen Bereichen kann durch geeignete horizontale Drehung des linearen Polarisationsfilters entweder ein dunkler, zu den Bereichen ohne die Nematenschicht kontrastierender Eindruck erzeugt werden oder die Bereiche zeigen ein helles Erscheinungsbild ohne wahrnehmbaren Kontrast zu den umgebenden metallisierten Bereichen.

Ein zu den Bereichen ohne Nematenschicht kontrastierender Eindruck entsteht dabei wie nachfolgend am Beispiel einer als λ/4-Plättchen ausgebildeten Schicht aus nematischem flüssigkristallinen Material beschrieben.

Das auf einen linearen Polarisationsfilter treffende (isoptrope) Licht verlässt jenen als linear polarisiertes Licht. Trift dieses im 45°-Winkel auf das λ/4-Plättchen aus nematischem flüssigkristallinen Material, wird das linear polarisierte Licht zu zirkular polarisiertem Licht umgewandelt. Trifft dieses auf einen Reflektor, z. B. in Form einer metallischen Schicht, wird zirkular polarisiertes Licht reflektiert, das erneut auf das λ/4-Plättchen trifft. Nach Durchlaufen des λ/4-Plättchens wird dieses zu linear polarisiertem Licht umgewandelt, wobei die Polarisationsebene jedoch um 90° gedreht ist. Dieses trifft auf den linearen Polfilter, der das in seiner Polarisationsebene nun um 90° gedrehte Licht sperrt, mit der Folge, dass der so ausgebildete Bereich unter dem Polarisationsfilter dunkel erscheint.

Ein dunkles Erscheinungsbild ergibt sich damit einerseits beim Auflegen eines Zirkularpolarisators (Fig. 4) auf eine reflektierende, insbesondere metallische Schicht, andererseits dann, wenn die λ/4-Schicht aus nematischem flüssigkristallinen Material die Funktion des λ/4-Plättchens im Zirkularpolarisator übernimmt.

Flüssigkristalline Schichten, die aus lösungsmittelhaltiger Formulierung hergestellt werden, können im Allgemeinen nur schwer in hoher Auflösung aufgebracht werden, da erhebliche Nassfilmdicken gedruckt werden müssten, die aufgrund der niedrigen Viskosität der Formulierungen einen erheblichen Verlauf bzw. ein "Fließen" nach dem Druck zeigen.

Für einen optimalen Kontrast bildet die nematische Flüssigkristallschicht eine λ/4-Schicht für Licht aus dem vorgesehenen Wellenlängenbereich. Je nach doppelbrechender Eigenschaft der Flüssigkristallmoleküle ist dafür eine bestimmte Schichtdicke (Größenordnung 1 g/m²) erforderlich, weshalb nicht beliebig dünn gedruckt werden kann. Die Zugabe von Verdickern führt in der Regel zu einem Qualitätsverlust bei den optischen Eigenschaften der Flüssigkristallschichten.

Optisch anisotope Folien im optischen Weg können den erzielbaren Kontrast ebenfalls vermindern, wodurch eine Releasefähigkeit von der Trägerfolie vorteilhaft ist. Sehr dünne UV-vernetzte (Flüssigkristall-)Schichten haben aber oft eine schlechte Releasefähigkeit.

Im Allgemeinen benötigen lösungsmittelbasierte Flüssigkristalllacke ausrichtungsfördernde Bedingungen, um ihre Wirkung entfalten zu können. In weiteren Verfahren werden für diesen Zweck spezielle Alignment- bzw. Ausrichtungsschichten eingesetzt. Insbesondere finden Alignmentschichten Verwendung, die aus einem linearen Photopolymer bestehen, das zur Ausrichtung einer geeigneten Strahlung ausgesetzt wird. Des Weiteren können flüssigkristalline Materialien auch mithilfe von Alignmentschichten ausgerichtet werden, die durch eine fein strukturierte Schicht oder eine durch Ausübung von Scherkräften ausgerichtete Schicht bereitgestellt werden.

Wird beispielsweise eine alignierende Prägestruktur mit zwei unterschiedlichen Orientierungen mit nematischem flüssigkristallinen Material beschichtet, führt die dadurch erzielte bereichsweise unterschiedliche Ausrichtung der Flüssigkristalle dazu, dass das Prägemotiv mit einem linearen Polarisationsfilter (durch Drehen des Polarisationsfilters) in Positiv- oder Negativkontrast sichtbar gemacht werden kann. Mit einem zirkularen Polarisationsfilter kann dagegen kein Motiv erkannt werden.

Es werden auch Sicherheitselemente mit latenten Bildern eingesetzt, bei denen die Flüssigkristallschicht auf einer flüssigkristallinen Mischung basiert, die dichroitische Farbstoffe enthält, wie beispielsweise in der Druckschrift WO 2019/068655 A1 beschrieben. Die flüssigkristalline Mischung wird dabei auf eine mit einer Prägung versehene Prägelackschicht aufgedruckt und im Rahmen eines Prägeprozesses ebenfalls geprägt. Dabei werden die Flüssigkristalle an beiden Grenzflächen unabhängig voneinander ausgerichtet. Zusammen mit dem dichroitischen Farbstoff entstehen dadurch Sicherheitsmerkmale, die von beiden Seiten unterschiedliche, voneinander unabhängige Motive zeigen, die sich mittels Bestrahlen mit linear polarisiertem Licht sichtbar machen lassen. Ein ähnlicher Ansatz ist in der Druckschrift EP 4 129 709 A1 beschrieben, gemäß der die Flüssigkristallschicht einen dichroitischen Farbstoff enthält, dessen Absorption von polarisiertem Licht von seiner Orientierung (im Verhältnis zur Orientierung der Polarisation des einfallenden polarisierten Lichts) abhängt. Bei Beleuchtung mit polarisiertem Licht lassen sich so Durchsicht-Sicherheitsmerkmale erzeugen. Eine beidseitige Prägung kann zu einem Auswalzen des ungehärteten Materials führen und damit zu undefinierten Motiven.

Ausgehend davon liegt der Erfindung die Aufgabe zugrunde, ein Sicherheitselement der eingangs genannten Art anzugeben, das die Nachteile des Standes der Technik vermeidet, einfach und kostengünstig herstellbar ist und dabei neben einem attraktiven Erscheinungsbild einen erhöhten Schutz gegenüber Fälschungen aufweist.

Diese Aufgabe wird durch die Merkmale der unabhängigen Ansprüche gelöst. Weiterbildungen der Erfindung sind Gegenstand der abhängigen Ansprüche.

Nach der Erfindung ist bei einem gattungsgemäßen Sicherheitselement vorgesehen, dass dieses eine auf einer Trägerfolie angeordnete erste Prägelackschicht, eine auf der ersten Prägelackschicht partiell vorliegende Motivschicht auf Basis eines nematischen flüssigkristallinen Materials und eine ein- oder mehrschichtige vollflächig vorliegende zweite Prägelackschicht umfasst.

Die dem nematischen flüssigkristallinen Material zugewandte Oberfläche der ersten Prägelackschicht ist dabei mit einer Prägung versehen, die zur Ausbildung eines zweiten latenten Motivs zumindest zwei Bereiche mit Ausrichtungsstrukturen unterschiedlicher Orientierung aufweist. Dabei bildet zumindest eine der Ausrichtungsstrukturen der motivbildenden Bereiche ein Gittermuster mit Strichgitterlinien, deren Beabstandung über die Fläche des motivbildenden Bereichs variiert, so dass die Ausrichtungsstruktur ein aperiodisches Gitter bildet.

Die Motivschicht ist in Form eines ersten latenten Motivs bereichsweise direkt auf der ersten Prägelackschicht und überlappend mit den das zweite latente Motiv bildenden Bereichen angeordnet, wobei das nematische flüssigkristalline Material durch die motivbildenden Bereiche in Form des zweiten latenten Motivs mit jeweils unterschiedlicher Orientierung homogen ausgerichtet ist, so dass das von den unterschiedlichen Ausrichtungsstrukturen gebildete Motiv bei Betrachtung durch einen Polarisator erkennbar ist.

Die zweite Prägelackschicht ist mit einer Prägung zur Erzeugung einer mikrooptischen Reliefstruktur und einer reflexionserhöhenden Beschichtung versehen.

Die Schicht aus nematischem flüssigkristallinem Material weist polarisationsabhängige optische Effekte auf, die mit dem Auge nicht wahrgenommen werden können, jedoch durch Hilfsmittel, z. B. durch Polarisationsfilter linearer oder zirkularer Art detektierbar sind, insbesondere mit solchen Hilfsmitteln für das Auge des Betrachters sichtbar gemacht werden können.

Durch die erfindungsgemäße variierende Beabstandung der Strichgitterlinien ist trotz der kleinen Abmessungen der Strichgitterlinien sichergestellt, dass der Darstellung des Sicherheitselements in den Bereichen des nematischen flüssigkristallinen Materials kein Beugungsmuster überlagert ist.

Anders als bei einer periodischen Anordnung gibt es bei einer aperiodischen Anordnung der Strichgitterlinien keinen einfachen, regelmäßigen Zusammenhang zwischen den Abständen benachbarter Strichgitterlinien. Dadurch wird eine konstruktive Interferenz des an benachbarten Strichgitterlinien reflektierten Lichts und damit das Entstehen eines überlagerten Beugungsmusters insbesondere in den Bereichen des nematischen flüssigkristallinen Materials zuverlässig verhindert.

Es hat sich zudem gezeigt, dass die ausrichtenden Eigenschaften der Ausrichtungsstrukturen durch die in Form einer Variation der Abstände vorliegende aperiodische Anordnung nicht beeinträchtigt werden.

Bevorzugt variiert die Beabstandung der Strichgitterlinien gemäß einer Zufallszahlenverteilung oder einer Pseudozufallszahlenverteilung. Pseudozufallszahlen sind Zahlenfolgen, die zwar zufällig erscheinen, aber durch einen deterministischen Algorithmus berechnet werden und daher im strengen Sinn keine echten Zufallszahlen sind. Dennoch werden Pseudozufallszahlen verbreitet eingesetzt, da die statistischen Eigenschaften einer Pseudozufallszahlenverteilung, wie Gleichwahrscheinlichkeit der einzelnen Zahlen oder die statistische Unabhängigkeit aufeinanderfolgender Zahlen, für praktische Zwecke in der Regel ausreichen und Pseudozufallszahlen mit Computern im Gegensatz zu echten Zufallszahlen einfach zu erzeugen sind. Eine Pseudozufallszahlenverteilung ist stets aperiodisch im Sinn der vorliegenden Anmeldung, da es bei einer Pseudozufallszahlenverteilung keinen festen, konstanten Abstand ("Periode") aufeinanderfolgender Werte gibt.

Eine aperiodische Variation der Beabstandung der Strichgitterlinien ist allerdings nicht auf Pseudozufallszahlenverteilungen beschränkt, sondern kann auch durch eine andere unregelmäßige Verteilung der Beabstandung erreicht werden.

In einer vorteilhaften Ausgestaltung bilden alle Ausrichtungsstrukturen der motivbildenden Bereiche jeweils ein Gittermuster mit Strichgitterlinien, deren Beabstandung über die Fläche des motivbildenden Bereichs variiert, so dass die Ausrichtungsstruktur ein aperiodisches Gitter bildet.

Mit Vorteil liegen die Ausrichtungsstrukturen in Form feiner Rillen oder Rinnen vor, durch die die Moleküle des nematischen flüssigkristallinen Materials ausgerichtet sind.

Für einen optimalen Kontrast bildet die Motivschicht mit Vorteil eine λ/4-Schicht für Licht aus dem vorgesehenen Wellenlängenbereich. Je nach Doppelbrechung der Flüssigkristallmoleküle ist dafür eine bestimmte Schichtdicke (Größenordnung 1 g/m²) erforderlich.

In einer vorteilhaften Ausgestaltung weist das aperiodische Gitter eine mittlere Periodenlänge von 0,2 µm bis 2,0 µm, vorzugsweise von 350 nm bis 800 nm, und eine Profiltiefe von 50 nm bis 600 nm, vorzugsweise von 200 nm bis 400 nm auf.

Mit Vorteil weist die Prägung der ersten Prägelackschicht zur Ausbildung des zweiten latenten Motivs zwei Bereiche mit Ausrichtungsstrukturen unterschiedlicher Orientierungsrichtungen auf, wobei die Orientierungsrichtungen relativ zueinander Winkel annehmen, die aus der Gruppe bestehend aus 45° und 135° gewählt sind.

Die erste Prägelackschicht liegt bevorzugt vollflächig vor. Zumindest in dem Bereich der Motivschicht weist diese mit Vorteil keine Bereiche ohne die Ausrichtung des flüssigkristallinen Materials fördernde Strukturen auf.

Mit Vorteil liegt der Brechungsindex der ersten und/oder der zweiten Prägelackschicht im sichtbaren Spektrum zwischen den orientierungsabhängigen Brechungsindizes der Motivschicht. Ebenso vorteilhaft unterscheiden sich die Brechungsindizes der ersten Prägelackschicht und der zweiten Prägelackschicht im sichtbaren Spektrum um nicht mehr als 0,1 insbesondere um nicht mehr als 0,05.

Die Ausrichtungsstrukturen können auch nur in dem Bereich der Motivschicht und insbesondere registergenau zu diesem vorgesehen sein.

In einer vorteilhaften Ausgestaltung enthält das erste latente Motiv ein oder mehrere erste Bildelemente und enthält das zweite latente Motiv eine Vielzahl von zweiten Bildelementen, wobei die ersten und zweiten Bildelemente alphanumerische Zeichen, Muster oder Codierungen umfassen. Mit Vorteil sind die zweiten Bildelemente dabei in einem Raster angeordnet.

Die mikrooptische Reliefstruktur ist mit Vorteil durch eine diffraktive Struktur, insbesondere eine ein- oder zweidimensionale periodische diffraktive Struktur, durch eine Mattstruktur, durch eine Subwellenlängenstruktur, insbesondere ein Subwellenlängengitter oder eine Mottenaugenstruktur, und/oder durch eine nicht-beugende Mikrostruktur, insbesondere eine Anordnung von (gerichtet reflektierenden) Mikrospiegeln oder Mikrolinsen, gebildet.

Die Erfindung enthält auch einen Datenträger mit einem Sicherheitselement der beschriebenen Art. Bei dem Datenträger kann es sich insbesondere um ein Wertdokument, wie eine Banknote, insbesondere eine Papierbanknote, eine Polymerbanknote oder eine Folienverbundbanknote, um eine Aktie, eine Anleihe, eine Urkunde, einen Gutschein, einen Scheck, ein Siegel, eine Steuerbanderole, eine hochwertige Eintrittskarte, aber auch um eine Ausweiskarte, wie etwa eine Kreditkarte, eine Bankkarte, eine Barzahlungskarte, eine Berechtigungskarte, einen Personalausweis oder eine Passpersonalisierungsseite handeln.

Die Erfindung stellt schließlich auch ein Verfahren zur Herstellung eines Sicherheitselements der beschriebenen Art bereit, bei dem
- auf eine Trägerfolie zur Ausbildung einer Ausrichtungsschicht zur homogenen Orientierung eines flüssigkristallinen Materials eine erste Prägelackschicht aufgebracht wird,
- die erste Prägelackschicht mit einer Prägung versehen wird, um zur Ausbildung eines zweiten latenten Motivs zumindest zwei Bereiche mit Ausrichtungsstrukturen unterschiedlicher Orientierung zu erzeugen, und der Prägelack ausgehärtet wird,
- eine Motivschicht auf Basis eines nematischen flüssigkristallinen Materials in Form eines ersten latenten Motivs bereichsweise direkt auf die erste Prägelackschicht und überlappend mit den das zweite latente Motiv bildenden Bereichen aufgebracht wird, wobei das nematische flüssigkristalline Material durch die Ausrichtungsstrukturen der motivbildenden Bereiche mit unterschiedlicher, homogener Orientierung ausgerichtet wird, so dass das von den unterschiedlichen Ausrichtungsstrukturen gebildete Motiv bei Betrachtung durch einen Polarisator erkennbar ist, wobei zumindest eine der Ausrichtungsstrukturen der motivbildenden Bereiche ein Gittermuster mit Strichgitterlinien bildet, deren Beabstandung über die Fläche des motivbildenden Bereichs variiert, so dass die Ausrichtungsstruktur ein aperiodisches Gitter bildet,
- das flüssigkristalline Material durch Beaufschlagung mit Strahlung gehärtet wird, und
- auf die Trägerfolie mit der Motivschicht eine ein- oder mehrschichtige zweite Prägelackschicht vollflächig aufgebracht wird, die zweite Prägelackschicht mit einer Prägung zur Erzeugung einer mikrooptischen Reliefstruktur versehen wird und anschließend mit einer reflexionserhöhenden Beschichtung versehen wird.

Gemäß einer vorteilhaften Ausgestaltung des Verfahrens wird die erste Prägelackschicht ohne Vorhärtung geprägt. Bevorzugt wird vor dem Aufbringen der ersten Prägelackschicht eine weitere Lackschicht auf die Trägerfolie aufgebracht und zumindest teilweise gehärtet.

Mit Vorteil wird das flüssigkristalline Material vor der Beaufschlagung mit Strahlung physikalisch getrocknet. Das flüssigkristalline Material wird bevorzugt durch Beaufschlagung mit UV-Strahlung gehärtet.

Wie die zweite Prägelackschicht wird auch die erste Prägelackschicht bevorzugt vollflächig aufgebracht. Mit besonderem Vorteil wird/werden die erste und/oder die zweite Prägelackschicht und/oder die Motivschicht aufgedruckt.

Besonders zweckmäßig ist es darüber hinaus, wenn die zweite Prägelackschicht metallisiert und gegebenenfalls bereichsweise demetallisiert wird.

In weiteren vorteilhaften Ausgestaltungen wird/werden eine oder mehrere weitere Schichten, insbesondere eine Primerschicht, eine Heißsiegellackschicht, eine Druckempfangsschicht und/oder eine Schutzschicht, auf die zweite Prägelackschicht aufgebracht, insbesondere aufgedruckt.

Zwischen der mit den Ausrichtungsstrukturen und der Motivschicht aus nematischem flüssigkristallinen Material versehenen ersten Prägelackschicht ("Flüssigkristallschicht-Aufbau") und der mit der reflexionserhöhenden Beschichtung versehenen zweiten Prägelackschicht ("Reflektor-Aufbau") - und damit im optischen Weg - können beliebige isotrope transparente Schichten eingesetzt werden. So kann beispielsweise in den Fällen, in denen sich das Sicherheitselement aus Teil-Elementen (Flüssigkristallschicht-Aufbau bzw. Reflektor-Aufbau) zusammensetzt, die getrennt hergestellt werden, ein isotroper transparenter Kaschierkleber vorgesehen sein. Ist beispielsweise die Zwischenhaftung nicht ausreichend, kann zudem ein ein- oder zweischichtiger Primer-Aufbau eingesetzt werden. Doppelbrechende Folien bzw. Folien, deren Doppelbrechung nicht genau spezifiziert ist oder deren Doppelbrechung stark wellenlängenabhängig ist, zwischen Betrachter und Reflektor sind hingegen zu vermeiden.

Nachfolgend wird die Erfindung anhand von Ausführungsbeispielen unter Bezugnahme auf die beigefügten Figuren, die ebenfalls erfindungswesentliche Merkmale offenbaren und bei deren Darstellung auf eine maßstabs- und proportionsgetreue Wiedergabe verzichtet wurde, noch näher erläutert. Diese Ausführungsbeispiele dienen lediglich der Veranschaulichung und sind nicht als einschränkend auszulegen. Die Darstellungen in den Figuren sind des besseren Verständnisses wegen stark schematisiert und spiegeln nicht die realen Gegebenheiten wider. Zur Vermeidung von Wiederholungen werden gleiche oder einander entsprechende Elemente in verschiedenen Figuren mit gleichen Bezugszeichen bezeichnet und nicht mehrmals erläutert. In den Figuren zeigen:
- Fig. 1: eine schematische Darstellung einer Banknote mit einem eingebetteten Sicherheitsfaden und einem aufgeklebten Transferelement,
- Fig. 2: eine Querschnittsansicht des Aufbaus eines Sicherheitselements nach einem Ausführungsbeispiel der Erfindung,
- Fig. 3: in (a) eine Aufsicht auf ein Ausführungsbeispiel eines Sicherheitselements mit einer strukturierten Ausrichtungsschicht und einer motivförmig aufgebrachten Flüssigkristallschicht, und in (b) eine vergrößerte Ansicht der Ausrichtungsstruktur,
- Fig. 4: eine schematische Darstellung eines Zirkularpolarisators,
- Fig. 5: eine Aufsicht auf das Sicherheitselement der Fig. 3, wie es bei Betrachtung (a) ohne Hilfsmittel, (b) bei Betrachtung mit einem zirkularen Polarisator, (c) bei Betrachtung mit einem linearen Polarisator in einer ersten Stellung und (d) bei Betrachtung mit einem linearen Polarisator in einer zweiten, dazu gedrehten Stellung erscheint.

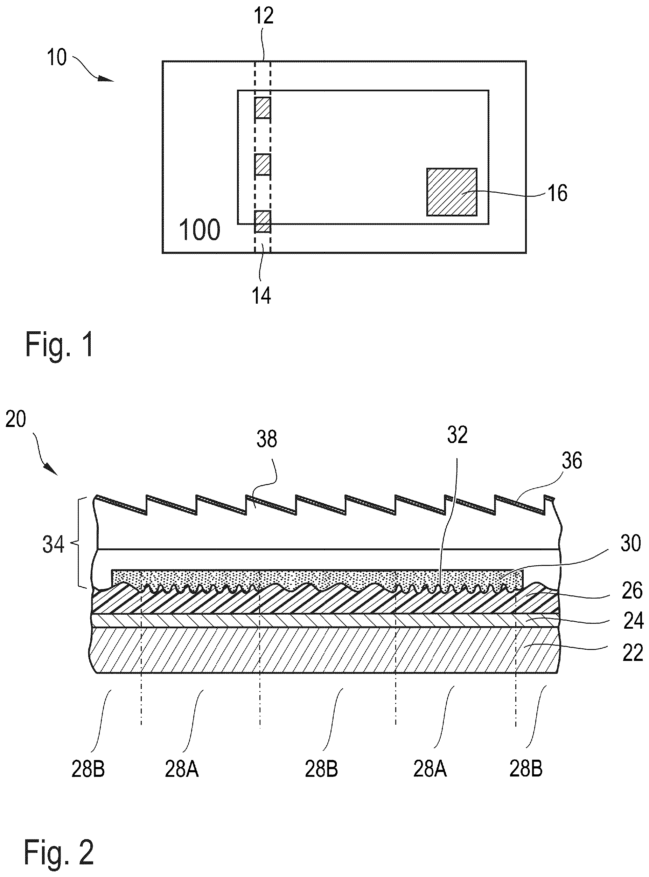

Die Erfindung wird nun am Beispiel von Sicherheitselementen für Banknoten erläutert. Fig. 1 zeigt dazu eine schematische Darstellung einer Banknote 10, die mit zwei Sicherheitselementen 12 und 16 nach Ausführungsbeispielen der Erfindung versehen ist. Das erste Sicherheitselement stellt einen Sicherheitsfaden 12 dar, der an bestimmten Fensterbereichen 14 an der Oberfläche der Banknote 10 hervortritt, während er in den dazwischen liegenden Bereichen im Inneren der Banknote 10 eingebettet ist. Das zweite Sicherheitselement ist durch ein aufgeklebtes Transferelement 16 beliebiger Form gebildet. Transferelemente können insbesondere als Patches oder Streifen jeweils mit oder ohne eigene Trägerschicht vorliegen. Das Sicherheitselement 16 kann auch in Form einer Abdeckfolie ausgebildet sein, die über einem Fensterbereich oder einer durchgehenden Öffnung der Banknote angeordnet ist.

Der Aufbau sowie die Herstellung eines Sicherheitselements 20 nach einem ersten Ausführungsbeispiel wird nun anhand des Querschnitts der Figur 2 näher erläutert.

Als Basis des Sicherheitselements 20 dient eine hochwertige gereckte PET-Trägerfolie 22, auf die im Ausführungsbeispiel eine dünne Schicht 24 aus einem UV-härtbaren Lack vollflächig aufgebracht wird. Auf die (teilweise oder vollständig ausgehärtete) Lackschicht 24 wird vollflächig ein UV-härtbarer Prägelack 26 aufgebracht, der im sogenannten "Casting" möglichst ohne Vorhärtung geprägt wird.

Die Teilbereiche 28A, 28B werden jeweils vollflächig mit einer Ausrichtungsstruktur 32 versehen. Die Ausrichtungsstruktur 32 besteht bereichsweise aus einer Vielzahl nebeneinander angeordneter, paralleler Rillen, die variierende Abstände aufweisen und eine Orientierung von Flüssigkristallmolekülen ermöglichen. Beispielsweise bilden diese Rillen in den Teilbereichen 28A und 28B jeweils ein aperiodisches Gitter mit einer mittleren Periodenlänge von 0,2 µm bis 2,0 µm, bevorzugt von 350 nm bis 800 nm, und einer Profiltiefe von 200 nm bis 600 nm. Auch geringere Profiltiefen sind denkbar, beispielsweise im Bereich von 50 nm. Die Längsrichtung dieser Rillen stellt hierbei die Orientierungsrichtung der Ausrichtungsstruktur in den Teilbereichen 28A und 28B dar.

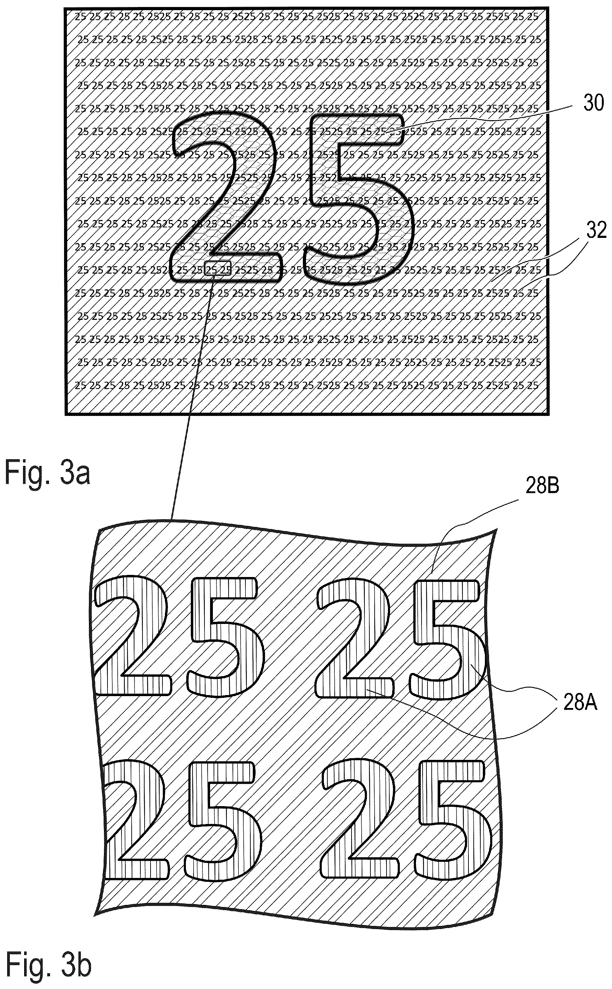

Wie der Darstellung der Figuren 2 und 3 zu entnehmen ist, ist die Orientierungsrichtung der Ausrichtungsstruktur 32 in den Teilbereichen 28A und 28B unterschiedlich. So weist der Teilbereich 28A beispielsweise eine Vielzahl von senkrecht angeordneten parallelen Rillen, der Teilbereich 28B eine Vielzahl von um 45° gegenüber der Senkrechten gedrehten parallelen Rillen auf. Die parallelen Rillen sind dabei mit variierender Beabstandung vorgesehen (in Fig. 3b angedeutet durch die Schraffur). Durch die aperiodische Anordnung der Rillen wird eine konstruktive Interferenz des an benachbarten Strichgitterlinien reflektierten Lichts und damit das Entstehen eines überlagerten Beugungsmusters insbesondere in den Bereichen des flüssigkristallinen Materials zuverlässig verhindert.

Im Fall einer als periodisches Gitter ausgebildeten Ausrichtungsstruktur können solche Effekte dort etwa bei starker Verkippung des Sicherheitselements auftreten. Bei einer periodischen Anordnung sind die Strichgitterlinien auf den Gitterpunkten eines regelmäßigen Gitterrasters angeordnet. Zwar werden in den Bereichen, in denen der UV-härtbare Prägelack 26 direkt mit einem ein- oder mehrschichtigen Prägelackaufbau 34 beschichtet ist, dessen Brechungsindex sich im sichtbaren Spektrum von dem des UV-härtbaren Prägelacks 26 nicht oder nur wenig, insbesondere um nicht mehr als 0,1 unterscheidet, etwaige Beugungseffekte im Wesentlichen ausgelöscht. In den mit nematischem flüssigkristallinem Material versehenen Bereichen des Sicherheitselements lassen sich allerdings sehr wohl mehr oder weniger stark ausgeprägte Beugungseffekte beobachten, insbesondere bei starker Verkippung des Sicherheitselements. Für ein latentes Sicherheitsmerkmal ist ein solches Verhalten unerwünscht.

Ohne an diese Erklärung gebunden zu sein, sind hierfür vermutlich die ausrichtungsbedingt unterschiedlichen Brechungsindizes des flüssigkristallinen Materials verantwortlich. So weisen die Flüssigkristalle längs der ursprünglichen Moleküle einen anderen Brechungsindex auf als quer dazu (z. B. n = 1,57, mit Δn = 0,14). Dies führt dazu, dass sich bei gezielter Ausrichtung des flüssigkristallinen Materials dessen Brechungsindex zumindest bei bestimmten Winkeln deutlich von dem des angrenzenden UV-härtbaren Prägelacks 26 unterscheidet und so selbst bei aufeinander abgestimmten Brechungsindizes (indem etwa der Brechungsindex des UV-Prägelacks 26 so gewählt ist, dass sein Brechungsindex zwischen den beiden orientierungsabhängigen Brechungsindizes der Flüssigkristallschicht 30 liegt) zu einem Brechungsindexsprung führen kann. Das flüssigkristalline Material wirkt in diesem Fall ähnlich wie eine HRI-Beschichtung.

Anders als bei einer periodischen Anordnung gibt es bei der erfindungsgemäßen aperiodischen Anordnung der Strichgitterlinien keinen einfachen, regelmäßigen Zusammenhang zwischen den Abständen benachbarter Strichgitterlinien. Dadurch wird eine konstruktive Interferenz des an benachbarten Strichgitterlinien reflektierten Lichts und damit das Entstehen eines überlagerten Beugungsmusters zuverlässig verhindert.

Es hat sich außerdem gezeigt, dass die ausrichtenden Eigenschaften der Ausrichtungsstrukturen durch die aperiodische Anordnung der im Ausführungsbeispiel als Rillen ausgebildeten Strichgitterlinien nicht beeinträchtigt werden.

Im Ausführungsbeispiel ist der Teilbereich 28A rasterförmig in Form einer Vielzahl sich wiederholender Bildelemente (kleine "25") vor dem durch den Teilbereich 28B gebildeten Hintergrund mit anderer (hier um 45° dazu gedrehter) alignierender Orientierung angeordnet ("Tapetenmotiv").

Auf die Ausrichtungsstruktur 32 wird eine dünne Schicht 30 aus einem nematischen flüssigkristallinen Material motivförmig (große "25") aufgebracht, insbesondere aufgedruckt. Für eine erhöhte Kantenschärfe kann es vorteilhaft sein, die Kanten bzw. Ränder des Motivs mit verringerter Grammatur anzulegen.

Das mithilfe des flüssigkristallinen Materials aufgebrachte Motiv kann vorteilhaft mit hoher Strichstärke vorliegen. Insbesondere können die Abmessungen des durch das flüssigkristalline Material 30 erzeugten Bildelemente so gewählt sein, dass diese deutlich, vorzugsweise um ein Vielfaches, größer sind als die Abmessungen der durch den Teilbereich 28A der Ausrichtungsstruktur 32 gebildeten Bildelemente.

Nach dem Aufbringen der Flüssigkristallschicht 30 orientieren sich die nematischen Flüssigkristalle in den Teilbereichen 28A, 28B homogen entsprechend der Vorgabe der Ausrichtungsstruktur 32. Die Flüssigkristall-Motivschicht 30 weist damit den Teilbereichen 28A, 28B entsprechende Bereiche auf, in denen sich die Orientierung der Flüssigkristalle unterscheidet. Die so erhaltene Ausrichtung wird, ggf. nach physikalischer Trocknung zur Entfernung etwaiger Lösungsmittel, durch Vernetzung der Flüssigkristallschicht 30 mit UV-Bestrahlung fixiert.

Auf die erhaltene Schichtenfolge wird ein ein- oder mehrschichtiger Prägelackaufbau 34 aufgebracht. In diesen wird eine Reliefstruktur 38, z. B. eine Hologrammstruktur, eine Mikrospiegelstruktur und/oder ein Subwellenlängengitter, geprägt, die anschließend mit einer reflexionserhöhenden Beschichtung, beispielsweise einer Metallisierung 36 versehen wird. In die vorzugsweise aufgedampfte Metallschicht 36 (z. B. aus Aluminium) können durch partielle Demetallisierung Aussparungen (nicht gezeigt), beispielsweise in Form einer Negativschrift eingebracht werden.

Die Aussparungen können mithilfe eines Ätzverfahrens oder eines Waschverfahrens erzeugt werden. Bei Einsatz eines Waschverfahrens werden vor dem Aufbringen der Metallschicht lösliche Waschfarben aufgedruckt, die nach der Bedampfung zusammen mit den darauf abgeschiedenen Substanzen der PVD-Schicht abgewaschen werden. Bei Einsatz eines Ätzverfahrens wird zunächst der PVD-Beschichtungsprozess durchgeführt, anschließend ein Resistlack gedruckt und strukturiert. In den ungeschützten Stellen wird die PVD-Schicht dann durch ein Ätzmittel entfernt. Der übrige Resistlack kann auf der PVD-Schicht verbleiben oder durch den Einsatz geeigneter Lösungsmittel entfernt werden.

Alternativ zu Metallschichten kann die Reliefstruktur 38 auch mit einer hochbrechenden Schicht versehen werden. Beispiele für geeignete hochbrechende Materialien sind CaS, Cr0₂, ZnS, Ti0₂ oder SiOₓ. Ebenso können auch Dünnschichtelemente mit Farbkippeffekt mittels eines PVD-Beschichtungsverfahrens auf die Reliefstruktur 38 aufgebracht und ggf. mit Aussparungen versehen werden. Derartige Dünnschichtelemente basieren insbesondere auf betrachtungswinkelabhängigen Interferenzeffekten durch Mehrfachreflexionen in den verschiedenen Teilschichten des Elements.

Das erhaltene Produkt kann direkt mit einer (nicht dargestellten) Primer-Schicht und Heißsiegellack heißsiegelfähig ausgestattet und beispielsweise auf ein Substrat 52, z. B. Papier, appliziert werden. Die Trägerfolie 22 kann dabei nach der Applikation auf das Substrat 52 entfernt werden oder als Abdeckfolie im Aufbau verleiben. Die letztgenannten Gestaltungen werden insbesondere bei der Aufbringung von Sicherheitselementen eingesetzt, die durchgehende Öffnungen in dem zu sichernden Gegenstand abdecken sollen. So wird beispielsweise bei einem T-LEAD (Longlasting Economical Anticopy Device)-Streifen (wobei T für "Transfer" steht), im Unterschied zu einem L-LEAD-Streifen, in der Regel eine gegebenenfalls vorhandene Trägerfolie nach der Applikation auf das Sicherheitspapier bzw. Wertdokument entfernt. L-LEAD-Gestaltungen werden insbesondere bei der Aufbringung von Sicherheitselementen eingesetzt, die durchgehende Öffnungen in dem zu sichernden Gegenstand abdecken sollen.

Vor dem Aufbringen des Heißsiegellacks können zudem weitere maschinell lesbare und/oder dekorative Schichten auf die ggf. teilweise demetallisierte Prägelackschicht 34, insbesondere auch in Überlappung mit der Metallisierung 36 aufgebracht werden. Der Heißsiegellack kann darüber hinaus maschinenlesbare Merkmalsstoffe, wie z.B. magnetische, elektrisch leitfähige, phosphoreszierende oder fluoreszierende Stoffe enthalten.

Auch zwischen dem mit der Ausrichtungsstruktur 32 und der Flüssigkristallschicht 30 versehenen Prägelack 26 ("Flüssigkristallschicht-Aufbau") und dem mit der Metallisierung 36 als reflexionserhöhender Beschichtung versehenen zweiten Prägelackaufbau 34 ("Reflektor-Aufbau") - und damit im optischen Weg - können beliebige isotrope transparente Schichten eingesetzt werden. So kann beispielsweise in den Fällen, in denen sich das Sicherheitselement 20 aus Teil-Elementen (Flüssigkristallschicht-Aufbau bzw. Reflektor-Aufbau) zusammensetzt, die getrennt hergestellt werden, ein isotroper transparenter Kaschierkleber vorgesehen sein. Ist beispielsweise die Zwischenhaftung nicht ausreichend, kann zudem ein ein- oder zweischichtiger Primer-Aufbau eingesetzt werden.

Der Schichtaufbau kann alternativ auch z.B. zu einem sogenannten Patch bzw. Einzel-Sicherheitselement weiterverarbeitet werden. Hierzu kann eine weitere Folie, z. B. eine PET-Folie mit einer geringen Dicke (z. B. 6 µm) auf den Schichtaufbau aufkaschiert werden. Auf die Seite der Trägerfolie 22 kann dann eine Stützfolie für den ggf. erfolgenden Schneid- bzw. Stanzprozess aufkaschiert werden, während die Oberfläche der genannten dünnen PET-Folie mit Primer und Heißsiegellack versehen werden kann. Nach dem Vorschneiden bzw. Stanzen der Umrissformen und Abgittern können die vorgefertigten Einzel-Sicherheitselemente (Patches) dann auf ein Substrat appliziert werden. Verfahren zur Herstellung eines solchen Sicherheitselement-Transfermaterials sowie Verfahren zum Übertragen eines Sicherheitselements aus dem Sicherheitselement-Transfermaterial auf einem Wertgegenstand sind beispielsweise in der Druckschrift WO 2010/031543 A1 beschrieben, deren Offenbarungsgehalt insoweit in die vorliegende Anmeldung aufgenommen wird.

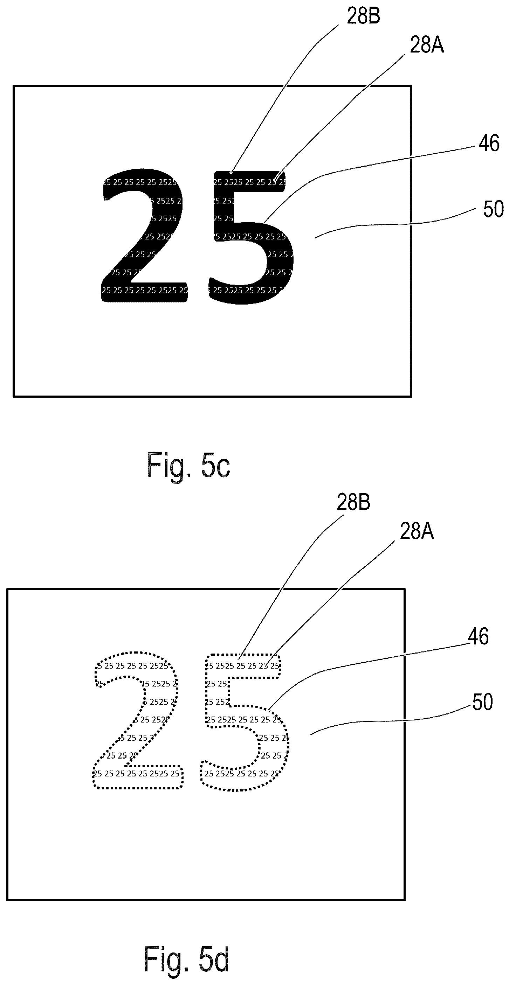

Fig. 5 zeigt eine Aufsicht auf ein Einzel-Sicherheitselement 40, wie es bei Betrachtung ohne Hilfsmittel erscheint. Ohne Hilfsmittel betrachtet, zeigt das Sicherheitselement 40 das Erscheinungsbild einer metallischen glänzenden, optisch variablen Mikrostruktur, im Ausführungsbeispiel ein mithilfe von Mikrospiegeln erzeugtes Reliefbild 44 in Wappenform (Fig. 5a).

Bei Betrachtung eines solchen Sicherheitselements 40 mit einem zirkularen Polarisationsfilter 42 kann das durch die Flüssigkristallschicht 30 erzeugte Bildmotiv 46 sichtbar gemacht werden und erscheint in diesem Bereich in Form des Zeichens "25" hell auf einem dunklen Hintergrund 50 (Fig. 5b). Ein Drehen des Polarisationsfilters 42 bewirkt keine Änderung des Erscheinungsbilds.

Ein weiteres Motiv kann bei Betrachtung des Sicherheitselements mit einem (nicht dargestellten) linearen Polarisationsfilter (oder einem durch die Rückseite betrachteten, also "umgedrehten" zirkularen Polarisationsfilter) sichtbar gemacht werden. In diesem Fall erscheinen die metallisch beschichteten Bereiche ohne die Flüssigkristallschicht - unabhängig von der Stellung des linearen Polarisationsfilters - immer hell, während der Betrachter 48 bei einer ersten Orientierung des linearen Polarisationsfilters im Bereich der Flüssigkristallschicht den Teilbereich 28B als großes Bildelement (große "25") dunkel und den Bereich 28A als helles Motiv in Form von rasterartig angeordneten kleinen Bildelementen (kleine "25") wahrnimmt (Fig. 5c).

Beim Drehen des linearen Polarisationsfilters ändern sich die relativen Helligkeiten und kehren sich bei einer Drehung um 45° im Bereich der Flüssigkristallschicht 30 gerade um, so dass nun die durch den Bereich 28A gebildeten kleinen Bildelemente als dunkles Motiv sichtbar werden, dessen durch eine gestrichelte Linie angedeuteter Umriss durch den Bereich der Flüssigkristallschicht 30 vorgegeben ist. Der dem Teilbereich 28B entsprechende Hintergrund erscheint in Form des Bildmotivs 46 ohne oder mit lediglich geringem Kontrast zu dem nicht mit der Flüssigkristallschicht 30 versehenen, ebenfalls hell erscheinendem Hintergrund 50 des Sicherheitselements 40 (Fig. 5d). Die kleinen Zeichen (kleine "25") werden hier zur Definition des größeren Zeichens (große "25") verwendet.

Ein besonderer Vorteil der beschriebenen Gestaltungen besteht darin, dass diese unterschiedliche latente Motive enthalten, die je nach Wahl des als Hilfsmittel eingesetzten Polarisationsfilters sichtbar gemacht werden können. Insbesondere können neben einem "makroskopischen", leicht erkennbaren Motiv auch sehr scharf begrenzte "mikroskopische" Motive erzeugt werden, da die Auflösung des polarisierenden Motivs nicht mehr ausschließlich durch die Druckgenauigkeit, sondern auch durch die Genauigkeit der Strukturierung der Prägelackschicht bestimmt ist.

Darüber hinaus verhindert die aperiodische Anordnung der Ausrichtungsstrukturen bzw. die Variation der Beabstandung der die Ausrichtungsstrukturen bildenden Strichgitterlinien wirksam etwaige störende Beugungseffekte, die andernfalls in bestimmten Betrachtungssituationen zu einer unerwünschten Sichtbarkeit des mit dem nematischen flüssigkristallinen Material erzeugten latenten Motivs führen könnten. Es sich zudem überraschenderweise gezeigt, dass die ausrichtenden Eigenschaften der Ausrichtungsstrukturen durch die in Form einer Variation der Abstände vorliegende aperiodische Anordnung nicht beeinträchtigt werden.

Darüber hinaus bietet die Erfindung ein visuell interessanteres Bild als bekannte latente Sicherheitsmarkmale auf Basis von Flüssigkristallen. Wenn ein Sicherheitselement für den Betrachter interessant ist, erhöht sich die Wahrscheinlichkeit, dass dieser dem Sicherheitselement und dem damit versehenen Wertgegenstand mehr Aufmerksamkeit schenkt, wodurch wiederum eine größere Sicherheitswirkung erreicht wird.

Da die unterschiedlichen Motive je nach Seite des (zirkularen) Polfilters, durch die das Sicherheitselement betrachtet wird, verwirrend sein können, kann auf dem als Verifikationsmedium verwendeten Polarisationsfilter auf der jeweils oben liegenden Seite das zu erwartende Motiv stilisiert wiedergegeben werden. Bei der einem linearen Polarisationsfilter in der Wirkung entsprechenden Seite eines zirkularen Polarisationsfilters ("umgedrehter" zirkularer Polarisationsfilter) bzw. bei einem linearen Polarisationsfilter können auch beide durch Drehung erreichbaren Motive stilisiert wiedergegeben werden.

Für eine Verifikation muss hier grundsätzlich einfallendes Licht und ausfallendes Licht polarisiert sein/werden, was durch Auflegen eines Polfilters erreicht werden kann. Es sind aber auch weitere Variationen denkbar. Beispielsweise kann die den Betrachtungsbereich erhellende Lichtquelle polarisiertes Licht aussenden. Unter diesen Umständen kann der Beobachter an einem beliebigen Punkt zwischen sich und dem Verifikationsgegenstand den Polarisationsfilter einsetzen, z. B. in Form einer polarisierenden Brille.

Die (optisch wichtigen) Arbeitsschritte bei der Herstellung des Sicherheitselements beginnen mit der ersten Prägung. Auf die damit erzeugte Ausrichtungsstruktur 32 wird das Motiv aus nematischem flüssigkristallinem Material 30 aufgebracht, insbesondere gedruckt. Die Ausrichtungsstruktur 32 wird von den nematischen Flüssigkristallen in diesem Bereich aufgefüllt (Profiltiefe der Ausrichtungsstruktur z. B. 200 nm, Schichtdicke der nematischen Flüssigkristallschicht z. B. 1 µm). Bei geeigneter Wahl des Brechungsindexes des UV-Prägelacks 26 verschwindet die Prägestruktur optisch.

Im Idealfall sind die Brechungsindizes der angrenzenden Materialien so aufeinander abgestimmt, dass keine starken Brechungsindexsprünge auftreten, die das Motiv der Ausrichtungsstruktur auch ohne Hilfsmittel und damit permanent sichtbar machen würden. Da Flüssigkristallschichten einen orientierungsabhängigen Brechungsindex haben, ist der UV-Prägelack 26 bevorzugt so zu wählen, dass sein Brechungsindex zwischen den beiden orientierungsabhängigen Brechungsindizes der Flüssigkristallschicht 30 liegt.

Wenn eine Erkennbarkeit der nematischen Flüssigkristallschicht bei Betrachtung des Sicherheitselements ohne Hilfsmittel nicht gewünscht ist, sollte zudem die Alignment-Qualität der Ausrichtungsstruktur 32 in allen Bereichen 28A, 28B vergleichbar sein.

In dem der Beschichtung mit flüssigkristallinem Material folgenden Arbeitsgang wird für die eigentliche Prägung, z. B. eines Hologramm- oder Mikrospiegelmotivs 44, vollflächig ein UV-Prägelack 34 (im Ausführungsbeispiel in zwei Stufen) aufgetragen. Damit liegt die nematische Flüssigkristallschicht 30 zwischen UV-Lackschichten eingebettet. Neben dem Nematenmotiv kommt die Prägelackschicht 34 direkt auf die bestehende Prägung 32 bzw. den Prägelack 26. Wenn die Brechungsindizes ähnlich sind, d. h. sich im sichtbaren Spektrum um nicht mehr als 0,1 und insbesondere um nicht mehr als 0,05 unterscheiden, verschwindet auch hier die "Alignment"-Prägung bzw. Ausrichtungsstruktur 32 optisch.

Die Flüssigkristallschicht 30 und der zweite Prägelackaufbau 34 können abweichende Brechungsindizes haben. Im Idealfall sind die Brechungsindizes auch hier so aufeinander abgestimmt, dass keine starken Brechungsindexsprünge auftreten.

Eine Begrenzung der ersten Prägung auf den Bereich, in dem das nematische flüssigkristalline Material gedruckt werden soll oder könnte (Passerschwankungen), ist möglich. Diese Begrenzung erfordert aber beim Druck des flüssigkristallinen Materials einen Insetter-Arbeitsgang, der mit erhöhtem Ausschuss verbunden sein kann.

Unabhängig davon kann ein Insetter-Arbeitsgang auch erforderlich sein, um zu vermeiden, dass die Schweißnähte (Prägewerkzeug mit Alignmentmotiv und Prägewerkzeug mit Motiv der Reliefstruktur) ins Motiv kommen und gegenseitig zu Problemen durch Aufbau führen.

### Bezugszeichenliste

- 10: Banknote
- 12: Sicherheitsfaden
- 14: Fensterbereiche
- 16: Transferelement
- 20: Sicherheitselement
- 22: Trägerfolie
- 24, 26: Prägelack
- 28A, 28B: Teilbereiche
- 30: Flüssigkristallschicht
- 32: Ausrichtungsstruktur
- 34: Prägelack
- 36: Metallisierung
- 38: Reliefstruktur
- 40: Sicherheitselement
- 42: Polarisator
- 44: Reliefbild
- 46: Bildmotiv
- 48: Betrachter
- 50: Hintergrund
- 52: Substrat

## Patentansprüche

1. Sicherheitselement zur Absicherung von Wertgegenständen, mit einer Motivschicht auf Basis eines flüssigkristallinen Materials, das zu Ausbildung eines latenten Motivs ausgelegt und bestimmt ist, **dadurch gekennzeichnet, dass**
- das Sicherheitselement eine auf einer Trägerfolie angeordnete erste Prägelackschicht, eine auf der ersten Prägelackschicht partiell vorliegende Motivschicht auf Basis eines nematischen flüssigkristallinen Materials und eine ein- oder mehrschichtige vollflächig vorliegende zweite Prägelackschicht umfasst,
- wobei die dem nematischen flüssigkristallinen Material zugewandte Oberfläche der ersten Prägelackschicht mit einer Prägung versehen ist, die zur Ausbildung eines zweiten latenten Motivs zumindest zwei Bereiche mit Ausrichtungsstrukturen unterschiedlicher Orientierung aufweist,
- wobei zumindest eine der Ausrichtungsstrukturen der motivbildenden Bereiche ein Gittermuster mit Strichgitterlinien bildet, deren Beabstandung über die Fläche des motivbildenden Bereichs variiert, so dass die Ausrichtungsstruktur ein aperiodisches Gitter bildet,
- wobei die Motivschicht in Form eines ersten latenten Motivs bereichsweise direkt auf der ersten Prägelackschicht und überlappend mit den das zweite latente Motiv bildenden Bereichen angeordnet ist, wobei das nematische flüssigkristalline Material durch die motivbildenden Bereiche in Form des zweiten latenten Motivs mit jeweils unterschiedlicher Orientierung homogen ausgerichtet ist, so dass das von den unterschiedlichen Ausrichtungsstrukturen gebildete Motiv bei Betrachtung durch einen Polarisator erkennbar ist,
- und wobei die zweite Prägelackschicht mit einer Prägung zur Erzeugung einer mikrooptischen Reliefstruktur und einer reflexionserhöhenden Beschichtung versehen ist.

2. Sicherheitselement nach Anspruch 1, **dadurch gekennzeichnet, dass** alle Ausrichtungsstrukturen der motivbildenden Bereiche jeweils ein Gittermuster mit Strichgitterlinien bilden, deren Beabstandung über die Fläche des motivbildenden Bereichs variiert, so dass die Ausrichtungsstruktur ein aperiodisches Gitter bildet.

3. Sicherheitselement nach Anspruch 1 oder 2, **dadurch gekennzeichnet, dass** die Ausrichtungsstrukturen in Form feiner Rillen oder Rinnen vorliegen, durch die die Moleküle des nematischen flüssigkristallinen Materials ausgerichtet sind.

4. Sicherheitselement nach einem der Ansprüche 1 bis 3, **dadurch gekennzeichnet, dass** das aperiodische Gitter eine mittlere Periodenlänge von 0,2 µm bis 2,0 µm, vorzugsweise von 350 nm bis 800 nm, und eine Profiltiefe von 50 nm bis 600 nm, vorzugsweise von 200 nm bis 400 nm aufweist.

5. Sicherheitselement nach einem der Ansprüche 1 bis 4, **dadurch gekennzeichnet, dass** die Beabstandung der Strichgitterlinien gemäß einer Zufallszahlenverteilung oder einer Pseudozufallszahlenverteilung variiert.

6. Sicherheitselement nach einem der obigen Ansprüche, **dadurch gekennzeichnet, dass** die Prägung der ersten Prägelackschicht zur Ausbildung des zweiten latenten Motivs zwei Bereiche mit Ausrichtungsstrukturen unterschiedlicher Orientierungsrichtungen aufweist, wobei die Orientierungsrichtungen relativ zueinander Winkel annehmen, die aus der Gruppe bestehend aus 45° und 135° gewählt sind.

7. Sicherheitselement nach einem der obigen Ansprüche, **dadurch gekennzeichnet, dass** die erste Prägelackschicht vollflächig vorliegt.

8. Sicherheitselement nach einem der obigen Ansprüche, **dadurch gekennzeichnet, dass** der Brechungsindex der ersten und/oder der zweiten Prägelackschicht im sichtbaren Spektrum zwischen den orientierungsabhängigen Brechungsindizes der Motivschicht liegt.

9. Sicherheitselement nach einem der obigen Ansprüche , **dadurch gekennzeichnet, dass** sich die Brechungsindizes der ersten Prägelackschicht und der zweiten Prägelackschicht im sichtbaren Spektrum um nicht mehr als 0,1, insbesondere um nicht mehr als 0,05 unterscheiden.

10. Sicherheitselement nach einem der obigen Ansprüche, **dadurch gekennzeichnet, dass** das erste latente Motiv ein oder mehrere erste Bildelemente enthält und das zweite latente Motiv eine Vielzahl von zweiten Bildelementen enthält, wobei die ersten und zweiten Bildelemente alphanumerische Zeichen, Muster oder Codierungen umfassen, wobei die zweiten Bildelemente vorzugsweise in einem Raster angeordnet sind.

11. Sicherheitselement nach einem der obigen Ansprüche, **dadurch gekennzeichnet, dass** die mikrooptische Reliefstruktur durch eine diffraktive Struktur, insbesondere ein- oder zweidimensionale periodische diffraktive Struktur, durch eine Mattstruktur, durch eine Subwellenlängenstruktur, insbesondere ein Subwellenlängengitter oder eine Mottenaugenstruktur, und/oder durch eine nicht-beugende Mikrostruktur, insbesondere eine Anordnung von Mikrospiegeln oder Mikrolinsen, gebildet ist.

12. Datenträger mit einem Sicherheitselement nach einem der Ansprüche 1 bis 11, wobei der Datenträger insbesondere ein Wertdokument oder eine Ausweiskarte ist.

13. Verfahren zur Herstellung eines Sicherheitselements zur Absicherung von Wertgegenständen, mit einer Motivschicht aus flüssigkristallinem Material, das zur Erzeugung einen latenten Motivs ausgelegt und bestimmt ist, wobei bei dem Verfahren
- auf eine Trägerfolie zur Ausbildung einer Ausrichtungsschicht zur homogenen Orientierung eines flüssigkristallinen Materials eine erste Prägelackschicht aufgebracht wird,
- die erste Prägelackschicht mit einer Prägung versehen wird, um zur Ausbildung eines zweiten latenten Motivs zumindest zwei Bereiche mit Ausrichtungsstrukturen unterschiedlicher Orientierung zu erzeugen, und der Prägelack ausgehärtet wird,
- eine Motivschicht auf Basis eines nematischen flüssigkristallinen Materials in Form eines ersten latenten Motivs bereichsweise direkt auf die erste Prägelackschicht und überlappend mit den das zweite latente Motiv bildenden Bereichen aufgebracht wird, wobei das nematische flüssigkristalline Material durch die Ausrichtungsstrukturen der motivbildenden Bereiche mit unterschiedlicher, homogener Orientierung ausgerichtet wird, so dass das von den unterschiedlichen Ausrichtungsstrukturen gebildete Motiv bei Betrachtung durch einen Polarisator erkennbar ist, wobei zumindest eine der Ausrichtungsstrukturen der motivbildenden Bereiche ein Gittermuster mit Strichgitterlinien bildet, deren Beabstandung über die Fläche des motivbildenden Bereichs variiert, so dass die Ausrichtungsstruktur ein aperiodisches Gitter bildet,
- das nematische flüssigkristalline Material durch Beaufschlagung mit Strahlung gehärtet wird, und
- auf die Trägerfolie mit der Motivschicht eine ein- oder mehrschichtige zweite Prägelackschicht vollflächig aufgebracht wird, die zweite Prägelackschicht mit einer Prägung zur Erzeugung einer mikrooptischen Reliefstruktur versehen wird und anschließend mit einer reflexionserhöhenden Beschichtung versehen wird.

14. Verfahren nach Anspruch 13, **dadurch gekennzeichnet, dass** die erste Prägelackschicht ohne Vorhärtung geprägt wird, wobei vor dem Aufbringen der ersten Prägelackschicht vorzugsweise eine weitere Lackschicht auf die Trägerfolie aufgebracht und zumindest teilweise gehärtet wird.

15. Verfahren nach Anspruch 13 oder 14, **dadurch gekennzeichnet, dass** das flüssigkristalline Material vor der Beaufschlagung mit Strahlung physikalisch getrocknet wird.

16. Verfahren nach wenigstens einem der Ansprüche 13 bis 15, **dadurch gekennzeichnet, dass** die erste Prägelackschicht vollflächig aufgebracht wird.
